(19)

Europäisches
Patentamt

European
Patent Office

Office européen
des brevets

(11) **EP 3 862 840 A1**

(12) **EUROPEAN PATENT APPLICATION**

(43) Date of publication:
**11.08.2021 Bulletin 2021/32**

(51) Int Cl.:
*G05F 1/46* (2006.01)    *G05F 1/56* (2006.01)

(21) Application number: **20156056.2**

(22) Date of filing: **07.02.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Renesas Electronics America Inc.
Milpitas, CA 95035 (US)**

(72) Inventor: **SCHMIDT, Martin
01187 Dresden (DE)**

(74) Representative: **Lippert Stachow Patentanwälte
Rechtsanwälte
Partnerschaft mbB
Krenkelstraße 3
01309 Dresden (DE)**

(54) **FULLY-DIFFERENTIAL VOLTAGE-CONTROLLED CURRENT SOURCE**

(57)    The invention relates to a fully-differential voltage-controlled current source (1), comprising:
an operational amplifier (2) with a positive input (3), a negative input (4), a negative output (5) and a positive output (6),
wherein a negative input voltage ($V_n$) is connected to the positive input (3) of the operational amplifier (2) via a negative input resistor ($R_{1n}$) and a positive input voltage ($V_p$) is connected to the negative input (4) of the operational amplifier (2) via a positive input resistor ($R1_p$),
wherein the negative output (5) of the operational amplifier (2) is connected to the positive input (3) of the operational amplifier (2) via a first negative feedback resistor ($R_{3n}$) and to the negative input (4) of the operational amplifier (2) via a series connection of a first current sense resistor ($R_{4n}$) and a first positive feedback resistor ($R_{2n}$),
wherein the positive output (6) of the operational amplifier (2) is connected to the negative input (4) of the operational amplifier (2) via a second negative feedback resistor ($R_{3p}$) and to the positive input (3) of the operational amplifier (2) via a series connection of a second current sense resistor ($R_{4p}$) and a second positive feedback resistor ($R_{3p}$), and
wherein a negative load output (7) is provided between the first current sense resistor ($R_{4n}$) and the first positive feedback resistor ($R_{2n}$) and a positive load output (8) is provided between the second current sense resistor ($R_{4p}$) and the second positive feedback resistor ($R_{2p}$).

Fig. 1

EP 3 862 840 A1

**Description**

The invention relates to a fully-differential voltage-controlled current source.

Many electronic devices require a controlled current for operation. For example, an inductive sensor may require a controlled current to excite a primary coil of the inductive sensor. This function can be fulfilled by a voltage-controlled current source (VCCS), which principally is known from the prior art. An example of such a known VCCS is a so-called Improved Howland Current Source. However, the VCCSs known from the prior art require a grounded load and cannot provide a fully-differential output for an ungrounded load.

It is therefore an object of the present invention to provide a fully-differential voltage-controlled current source.

According to the invention the object is solved by a fully-differential voltage-controlled current source, comprising:

an operational amplifier with a positive input, a negative input, a negative output and a positive output,

wherein a negative input voltage is connected to the positive input of the operational amplifier via a negative input resistor and a positive input voltage is connected to the negative input of the operational amplifier via a positive input resistor,

wherein the negative output of the operational amplifier is connected to the positive input of the operational amplifier via a first negative feedback resistor and to the negative input of the operational amplifier via a series connection of a first current sense resistor and a first positive feedback resistor,

wherein the positive output of the operational amplifier is connected to the negative input of the operational amplifier via a second negative feedback resistor and to the positive input of the operational amplifier via a series connection of a second current sense resistor and a second positive feedback resistor, and

wherein a negative load output is provided between the first current sense resistor and the first positive feedback resistor and a positive load output is provided between the second current sense resistor and the second positive feedback resistor.

The operational amplifier of the fully-differential voltage-controlled current source is operated as a differential amplifier. The fully-differential voltage-controlled current source according to the invention regulates the differential current through the first current sense resistor and the second current sense resistor.

The operational amplifier and the described resistor network provide a fully-differential voltage-controlled current source with a high output impedance. Furthermore, the fully-differential voltage-controlled current source has a high robustness against electromagnetic interference (EMI). The differential output of the circuit behaves like a current source while the common mode voltage of the output is set by the amplifiers common mode feedback loop.

In a variant of the invention the negative input resistor is equal to the positive input resistor. Thus, the input impedance for the negative input voltage and the positive input voltage is identical.

According to a further variant of the invention the first positive feedback resistor is equal to the second positive feedback resistor. And in a further variant of the invention the first negative feedback resistor is equal to the second negative feedback resistor. Pursuant to another variant of the invention the first current sense resistor is equal to the second current sense resistor. The matching of the positive feedback resistors, the negative feedback resistors and the current sense resistors is important for a high output impedance of the current source.

In a further variant of the invention the first positive feedback resistor is equal to a series connection of the first negative feedback resistor and the first current sense resistor. According to a corresponding variant of the invention the second positive feedback resistor is equal to a series connection of the second negative feedback resistor and the second current sense resistor.

In the following the invention will be further explained with respect to the embodiment shown in the figure. It shows:

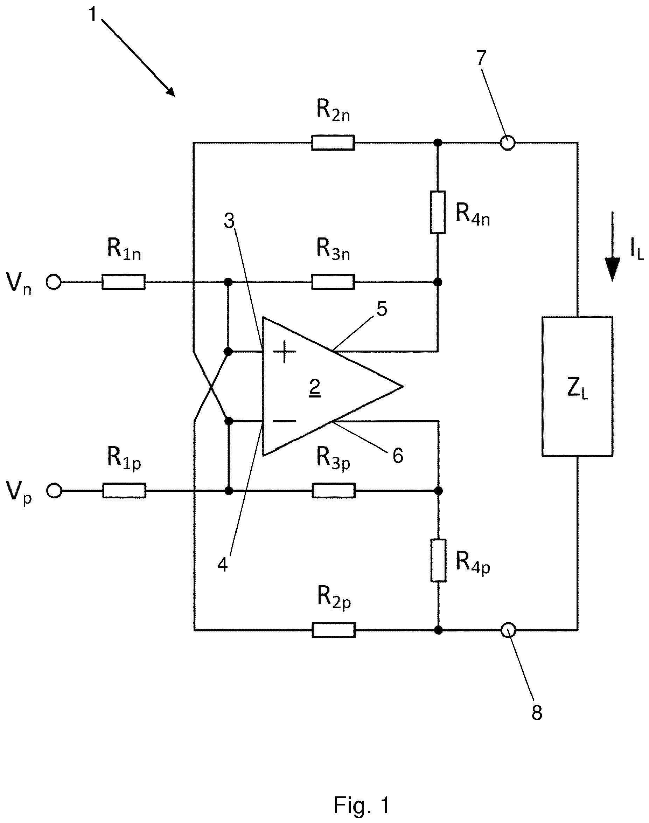

Fig. 1　　a block diagram of a fully-differential voltage-controlled current source according to the invention.

Fig. 1 shows a block diagram of an embodiment of a fully-differential voltage-controlled current source 1 according to the invention. The fully-differential voltage-controlled current source 1 comprises an operational amplifier 2. The operational amplifier 2 is operated in a differential mode and has a positive input 3, a negative input 4, a negative output 5 and a positive output 6.

A negative voltage input $V_n$ is connected to the positive input 4 of the operational amplifier 2 via a negative input resistor $R_{1n}$. Likewise, a positive input voltage $V_p$ is connected to the negative input 4 of the operational amplifier 2 via a positive input resistor $R_{1p}$.

The negative output 5 of the operational amplifier 2 is connected to the positive input 3 of the operational amplifier 2 via a first negative feedback resistor $R_{3n}$. The negative output 5 of the operational amplifier 2 is further connected to the negative input 4 of the operational amplifier 2 via a series connection of a first current sense resistor $R_{4n}$ and a first positive feedback resistor $R_{2n}$. Particularly, the first current sense resistor $R_{4n}$ is connected to the negative output 5 of the operational amplifier 2 and the first positive feedback resistor $R_{2n}$ is connected to the negative input 4 of the operational amplifier 2. A negative load output 7 is provided between the first current sense resistor $R_{4n}$ and the first positive feedback resistor $R_{2n}$.

The positive output 6 of the operational amplifier 2 is connected to the negative input 4 of the operational amplifier 2 via a second negative feedback resistor $R_{3p}$. The positive output 6 of the operational amplifier 2 is further connected to the positive input 3 of the operational amplifier 2 via a series connection of a second current sense resistor $R_{4p}$ and a second positive feedback resistor $R_{2p}$. Particularly, the second current sense resistor $R_{4p}$ is connected to the positive output 6 of the operational amplifier 2 and the second positive feedback resistor $R_{2p}$ is connected to the positive input 3 of the operational amplifier 2. A positive load output 8 is provided between the second current sense resistor $R_{4p}$ and the second positive feedback resistor $R_{2p}$.

In general, the input resistor is referred to as $R_1$, the positive feedback resistor is referred to as $R_2$, the negative feedback resistor is referred to as $R_3$, and the current sense resistor is referred to as $R_4$.

The load $Z_L$ is connected between the negative load output 7 and the positive load output 8. The fully-differential voltage-controlled current source 1 of the invention controls the current $I_L$ through load $Z_L$. Load $Z_L$ is for example an inductive sensor which requires a controlled current to excite a primary coil of the inductive sensor.

As can be seen from Fig. 1 the operational amplifier 2 and resistor network $R_1, R_2, R_3, R_4$ can be divided into a first upper side and a second lower side. The upper side is also referred to as negative side, indicated by indices n attached to the above-mentioned resistor references $R_{1n}, R_{2n}, R_{3n}, R_{4n}$. Likewise, the lower side is referred to as positive side, indicated by indices p attached to the above-mentioned resistor references $R_{1p}, R_{2p}, R_{3p}, R_{4p}$.

In the embodiment shown in Fig. 1 the negative input resistor $R_{1n}$ is equal to the positive input resistor $R_{1p}$, the first positive feedback resistor $R_{2n}$ is equal to the second positive feedback resistor $R_{2p}$, the first negative feedback resistor $R_{3n}$ is equal to the second negative feedback resistor $R_{3p}$ and the first current sense resistor $R_{4n}$ is equal to the second sense resistor $R_{4p}$, resulting in:

$$R_1 = R_{1n} = R_{1p}$$

$$R_2 = R_{2n} = R_{2p}$$

$$R_3 = R_{3n} = R_{3p}$$

$$R_4 = R_{4n} = R_{4p}$$

Furthermore, the first positive feedback resistor $R_{2n}$ is equal to a series connection of the first negative feedback resistor $R_{3n}$ and the first current sense resistor $R_{4n}$ and the second positive feedback resistor $R_{2p}$ is equal to a series connection of the second negative feedback resistor $R_{3p}$ and the second current sense resistor $R_{4p}$, resulting in:

$$R_{2n} = R_{3n} + R_{4n}$$

respectively

$$R_{2p} = R_{3p} + R_{4p}$$

or generally

$$R_2 = R_3 + R_4.$$

Considering the above, the transfer function of the fully-differential voltage-controlled current source 1 of the embodiment shown in Fig. 1 is given by:

$$\frac{I_L}{V_P - V_N} = \frac{1}{2R_1}\left(1 + \frac{R_3}{R_4}\right)$$

**List of reference numerals**

| | |
|---|---|
| 1 | fully-differential voltage-controlled current source |
| 2 | operational amplifier |
| 3 | positive input |
| 4 | negative input |
| 5 | negative output |
| 6 | positive output |
| 7 | negative load output |
| 8 | positive load output |
| $V_n$ | negative input voltage |
| $V_p$ | positive input voltage |
| $R_1$ | input resistor |
| $R_{1n}$ | negative input resistor |
| $R_{1p}$ | positive input resistor |
| $R_2$ | positive feedback resistor |
| $R_{2n}$ | first positive feedback resistor |
| $R_{2p}$ | second positive feedback resistor |
| $R_3$ | negative feedback resistor |
| $R_{3n}$ | first negative feedback resistor |
| $R_{3p}$ | second feedback resistor |
| $R_4$ | current sense resistor |
| $R_{4n}$ | first current sense resistor |
| $R_{4p}$ | second current sense resistor |
| $Z_L$ | load |
| $I_L$ | load current |

**Claims**

1. Fully-differential voltage-controlled current source (1), comprising:

an operational amplifier (2) with a positive input (3), a negative input (4), a negative output (5) and a positive output (6),
wherein a negative input voltage ($V_n$) is connected to the positive input (3) of the operational amplifier (2) via a negative input resistor ($R_{1n}$) and a positive input voltage ($V_p$) is connected to the negative input (4) of the operational amplifier (2) via a positive input resistor ($R1_p$),
wherein the negative output (5) of the operational amplifier (2) is connected to the positive input (3) of the operational amplifier (2) via a first negative feedback resistor ($R_{3n}$) and to the negative input (4) of the operational amplifier (2) via a series connection of a first current sense resistor ($R_{4n}$) and a first positive feedback resistor ($R_{2n}$),
wherein the positive output (6) of the operational amplifier (2) is connected to the negative input (4) of the operational amplifier (2) via a second negative feedback resistor ($R_{3p}$) and to the positive input (3) of the operational amplifier (2) via a series connection of a second current sense resistor ($R_{4p}$) and a second positive feedback resistor ($R_{3p}$), and
wherein a negative load output (7) is provided between the first current sense resistor ($R_{4n}$) and the first positive feedback resistor ($R_{2n}$) and a positive load output (8) is provided between the second current sense resistor ($R_{4p}$) and the second positive feedback resistor ($R_{2p}$).

2. Fully-differential voltage-controlled current source (1) according to claim 1,
wherein the negative input resistor ($R_{1n}$) is equal to the positive input resistor ($R_{1p}$).

3. Fully-differential voltage-controlled current source (1) according to claim 1 or claim 2,
wherein the first positive feedback resistor ($R_{2n}$) is equal to the second positive feedback resistor ($R_{2p}$).

4. Fully-differential voltage-controlled current source (1) according to any of claims 1 to 3,
wherein the first negative feedback resistor ($R_{3n}$) is equal to the second negative feedback resistor ($R_{3p}$).

5. Fully-differential voltage-controlled current source (1) according to any of claims 1 to 4,
wherein the first current sense resistor ($R_{4n}$) is equal to the second current sense resistor ($R_{4p}$).

6. Fully-differential voltage-controlled current source (1) according to any of claims 1 to 5,
wherein the first positive feedback resistor ($R_{2n}$) is equal to a series connection of the first negative feedback resistor ($R_{3n}$) and the first current sense resistor ($R_{4n}$) .

7. Fully-differential voltage-controlled current source (1) according to any of claims 1 to 6,
wherein the second positive feedback resistor ($R_{2p}$) is equal to a series connection of the second negative feedback resistor ($R_{3p}$) and the second current sense resistor ($R_{4p}$).

Fig. 1

Europäisches
Patentamt

European
Patent Office

Office européen
des brevets

# EUROPEAN SEARCH REPORT

Application Number

EP 20 15 6056

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | VINICIUS G SIRTOLI ET AL: "Design of current sources for load common mode optimization", JOURNAL OF ELECTRICAL BIOIMPEDANCE, vol. 9, no. 1, 30 November 2018 (2018-11-30), pages 59-71, XP055684903, DOI: 10.2478/joeb-2018-0011 * page 62 - page 64; figure 7 * | 1-7 | INV. G05F1/46 G05F1/56 |
| A | TRUJILLO H ET AL: "Multi-purpose electronic circuit", ELECTRONICS LETTERS, IEE STEVENAGE, GB, vol. 36, no. 9, 27 April 2000 (2000-04-27), pages 776-778, XP006015152, ISSN: 0013-5194, DOI: 10.1049/EL:20000595 * abstract; figures 1-3 * | 1-7 | |
| A | BERTEMES-FILHO P ET AL: "Mirrored Modified Howland Circuit for Bioimpedance Applications: Analytical Analysis", JOURNAL OF PHYSICS: CONFERENCE SERIES, INSTITUTE OF PHYSICS PUBLISHING, BRISTOL, GB, vol. 407, no. 1, 20 December 2012 (2012-12-20), page 12030, XP020235869, ISSN: 1742-6596, DOI: 10.1088/1742-6596/407/1/012030 * abstract; figure 2 * | 1-7 | TECHNICAL FIELDS SEARCHED (IPC)<br><br>G05F |

The present search report has been drawn up for all claims

| Place of search | Date of completion of the search | Examiner |
|---|---|---|
| The Hague | 17 July 2020 | Arias Pérez, Jagoba |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)